# EUROPÄISCHE PATENTANMELDUNG

(11) **EP 1 953 877 A1**
(43) Veröffentlichungstag der Anmeldung: **06.08.2008**
(21) Anmeldenummer: 07101511.9
(22) Anmeldetag: 31.01.2007
(51) Int. Cl.: H01R 13/53

(54) **Spannungszuführung zu wenigstens einem elektrischen Verbraucher**

(71) Anmelder: Applied Materials, Inc., Santa Clara, CA 95054 (US)
(72) Erfinder: Hacker, Volker, 63674, Altenstadt-Oberau (DE); Klemm, Günter, 63667, Nidda (DE)
(74) Vertreter: Schickedanz, Willi

(57) **Zusammenfassung**

Die Erfindung betrifft eine Spannungszuführung mittels Kabel zu elektrischen Geräten, die sich in einer Vakuumkammer befinden. Mit dieser Spannungszuführung soll verhindert werden, dass sich innerhalb des Kabels entlang der Isolierstrecke - im Wesentlichen der Raum zwischen der Seele des Kabels und seiner Abschirmung sowie im Übergangsbereich von Kabel und elektrischem Gerät- Entladungen ausbilden, die zu Isolierschäden führen. Erreicht wird dies dadurch, dass die Isolierstrecken unter Atmosphärendruck gehalten werden. Hierzu werden besondere Kupplungen verwendet, die eine Verbindung zwischen einem Kabelende und den elektrischen Geräten herstellen. Außerdem können die Kabel noch mit zusätzlichen Luftkanälen versehen werden.

## Beschreibung

Die Erfindung betrifft eine Spannungszuführung nach dem Oberbegriff des Patentanspruchs 1.

In Vakuumkammern sind oft elektrische Verbraucher vorgesehen, denen Hochspannung oder Hochfrequenzspannung zugeführt werden muss. Beispiele für solche Verbraucher sind Ionen- oder Elektronenquellen. Bisweilen sind beide Verbrauchertypen auch gleichzeitig in einer Vakuumkammer angeordnet, beispielsweise wenn eine zu beschichtende Folie zuerst mit Elektronen elektrostatisch aufgeladen wird, damit sie an einer Walze besser haftet, und dann mittels positiver Ionen wieder entladen wird.

Werden solche Verbraucher über Kabel mit elektrischer Energie versorgt, so können sich - insbesondere in einem Druckbereich von 0,01 mbar bis 0,1 mbar - entlang der Isolierstrecke Plasmen oder Glimmentladungen ausbilden, die das Kabel zerstören. Unter einer Isolierstrecke wird im Folgenden der Raum zwischen der Seele eines Kabels und der im Kabel vorhandenen Abschirmung und/oder dem Übergang zwischen dem Kabelende und dem elektrischen Verbraucher verstanden.

Es ist bereits ein Koaxialkabel bekannt, mit dem Gleich- oder Wechselstrom im Vakuum übertragen werden kann (US 5 154 635). Dieses Kabel weist einen inneren elektrisch leitenden Draht sowie mehrere elektrisch-isolierende linsenförmige Scheiben auf, die in ihrer Mitte eine Durchbohrung aufweisen, wobei der elektrisch leitende Draht durch diese Durchbohrungen geführt ist.

Es ist weiterhin ein Koaxialkabel bekannt, mit dem ein Hochfrequenzsignal zu einer Vorrichtung gegeben werden kann, die sich im Ultra-Hochvakuum befindet (JP 06007664 A). Dieses Koaxialkabel wird über einen Vakuumflansch in einen Vakuumkessel eingebracht. Dabei ist ein flexibler Schlauch mit dem Flansch verbunden und das Kabel wird mittels dieses Schlauchs eingeführt. Der Schlauch ist über einen Zylinder mit der Vorrichtung verbunden, wobei das Kabel über einen Eingangsanschluss in die Vorrichtung eingeführt wird. Am Eingangsanschluss ist ein keramischer Isolator vorgesehen, der das Vakuum zur Außenseite hin abdichtet. Da die Vakuumseite von der Außenseite - d. h. der Atmosphärenseite - an der Geräteseite abgedichtet ist, kann ein normales Koaxialkabel verwendet werden.

Der Erfindung liegt die Aufgabe zugrunde, einen elektrischen Anschluss für elektrische Verbraucher in einer Vakuumkammer zu schaffen, bei dem es nicht zu Entladungen kommt.

Diese Aufgabe wird gemäß den Merkmalen des Patentanspruchs 1 gelöst.

Die Erfindung betrifft eine Spannungszuführung mittels Kabel zu elektrischen Geräten, die sich in einer Vakuumkammer befinden. Mit dieser Spannungszuführung soll verhindert werden, dass sich innerhalb des Kabels entlang der Isolierstrecke - im Wesentlichen der Raum zwischen der Seele des Kabels und seiner Abschirmung sowie im Übergangsbereich von Kabel und elektrischem Gerät - Entladungen ausbilden, die zu Isolierschäden führen. Erreicht wird dies dadurch, dass die Isolierstrecken unter Atmosphärendruck gehalten werden. Hierzu werden besondere Kupplungen verwendet, die eine Verbindung zwischen einem Kabelende und den elektrischen Geräten herstellen. Außerdem können die Kabel noch mit zusätzlichen Luftkanälen versehen werden.

Der mit der Erfindung erzielte Vorteil besteht insbesondere darin, dass Überschläge und dergleichen entlang der Isolierstrecke vermieden werden und handelsübliche Kabel verwendet werden können. Ohne den Einsatz der Erfindung hätte das Vakuum der Vakuumkammer einen negativen Einfluss auf das Innere des Kabels.

Ausführungsbeispiele der Erfindung sind in den Zeichnungen dargestellt und werden im Folgenden näher beschrieben. Es zeigen:
Fig. 1 eine Prinzipdarstellung einer Vakuumkammer mit Verbrauchern, die mit Hochspannung oder Hochfrequenzspannung betrieben werden;
Fig. 2 eine Elektronenquelle mit einem elektrischen Hochspannungsanschluss;
Fig. 3 eine Seitenansicht des in der Fig. 2 gezeigten Hochspannungsanschlusses;
Fig. 4 eine Ansicht des Hochspannungsanschlusses, wobei der Hochspannungsanschluss gegenüber seiner in der Fig. 3 gezeigten Position um 180 Grad um seine Längsachse gedreht ist;
Fig. 5 eine Explosionsdarstellung des Hochspannungsanschlusses;
Fig. 6 eine Swagelok-Verschraubung;
Fig. 7 einen Schnitt durch den Hochspannungsanschluss;
Fig. 8a einen Querschnitt durch ein Hochspannungskabel im Vakuum;
Fig. 8b einen Längsschnitt durch ein Hochspannungskabel im Übergangsbereich von Atmosphäre zu Vakuum;
Fig. 9 eine Seitenansicht eines Hochfrequenzanschlusses;
Fig. 10 einen Schnitt durch den Hochfrequenzanschluss gemäß Fig. 9;
Fig. 11 eine Explosionsdarstellung des Hochfrequenzanschlusses gemäß Fig. 9.

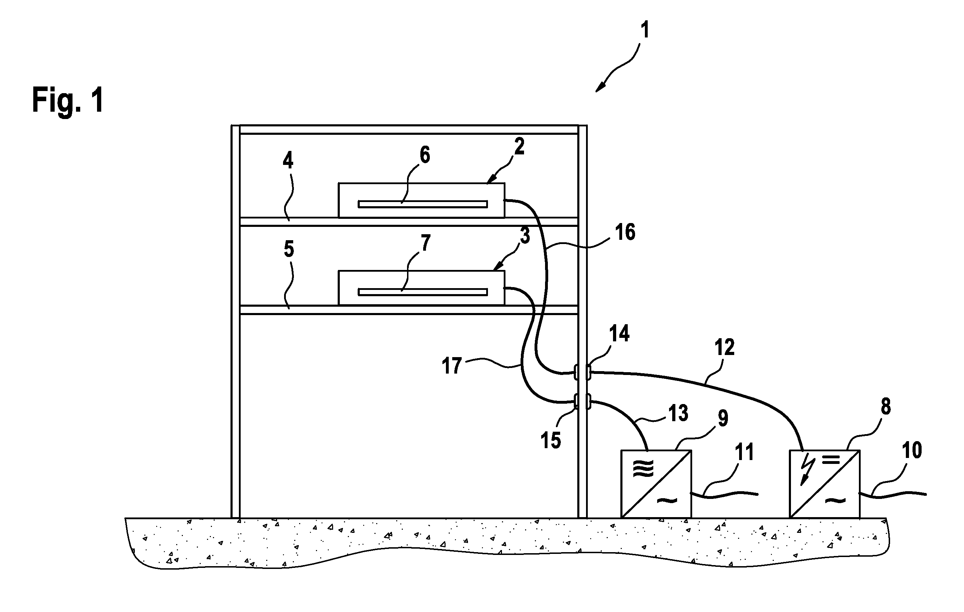

In der Fig. 1 ist schematisch eine Vakuumkammer 1 dargestellt, die eine Elektronenquelle 2 und eine Ionenquelle 3 enthält. Die Elektronenquelle 2 und die Ionenquelle 3 befinden sich auf Böden 4, 5 oder sind auf andere Weise in der Vakuumkammer 1 befestigt.

Sowohl bei der Elektronenquelle 2 als auch bei der Ionenquelle 3 handelt es sich um lineare Quellen, bei denen die Ionen bzw. Elektronen aus einem Schlitz 6, 7 austreten. Eine Elektronenquelle dieser Art ist in der europäischen Patentanmeldung 06 012 961.6 näher beschrieben.

Vor der Elektronenquelle 2 und der Ionenquelle 3 läuft während des Betriebs eine nicht dargestellte zu beschichtende Folie von oben nach unten, die durch die Elektronenquelle 2 elektrisch negativ aufgeladen und anschließend durch die Ionenquelle 3 elektrisch neutralisiert wird.

Während die Elektronenquelle 2 von einem Hochspannungsgleichstrom-Generator 8 aus versorgt wird, wird die Ionenquelle 3 von einem Hochfrequenzgenerator 9 aus versorgt. Beide Generatoren 8, 9 liegen mit ihren Eingangsanschlüssen 10, 11 an einem Wechselstromnetz. Die Hochspannungsgleichspannung bzw. die Hochfrequenzspannung sind über Kabel 12, 13 und Durchführungen 14, 15 in die Vakuumkammer 1 eingeführt. Bei der Durchführung 14 handelt es sich um eine Hochspannungs-Vakuumdurchführung, die z. B. mittels einer Swagelok-Verschraubung realisiert wird. Diese Verschraubung dichtet mit ihrer kegelartigen Dichtung auf einem normalen Vakuumschlauch ab. Die Durchführung 15 entspricht im Wesentlichen der Durchführung 14. Bei der Durchführung 15 wird jedoch direkt auf der Außenhülle des Hochfrequenzkabels 13 abgedichtet. "Swagelok" ist ein Handelsname und steht für ein bestimmtes Dichtungssystem, das in der Hydraulik- und Vakuumtechnik eingesetzt wird. Es ist indessen nicht notwendig, diese Dichtungsart einzusetzen. Andere Dichtungen können denselben Zweck erfüllen.

Von den Durchführungen 14, 15 verlaufen die Kabel 12, 13 bis zu der Elektronenquelle 2 bzw. der Ionenquelle 3. Die in der Vakuumkammer verlaufenden Teile der Kabel 12, 13 sind mit den Bezugszahlen 16, 17 versehen. Sie sind anders aufgebaut als die in Atmosphäre verlaufenden Kabel 12, 13.

Selbst wenn diese Kabel 16, 17 abgeschirmt sind, besteht die Gefahr, dass im Vakuum der Vakuumkammer 1 entlang der Isolierstrecke der Kabel 16, 17 Entladungen entstehen, welche die in der Vakuumkammer 1 befindlichen Teilchenquellen 2, 3 zerstören können. Es muss deshalb in besonderer Weise darauf geachtet werden, in welcher Weise die Zufuhr der elektrischen Leistung zu der Elektronenquelle 2 und der Ionenquelle 3 innerhalb der Vakuumkammer 1 erfolgt. Die Durchführungen 14, 15 sind so ausgeführt, dass sie am Außenmantel des vakuumdichten Schlauchs bzw. am Außenmantel des HF-Kabels abgedichtet sind.

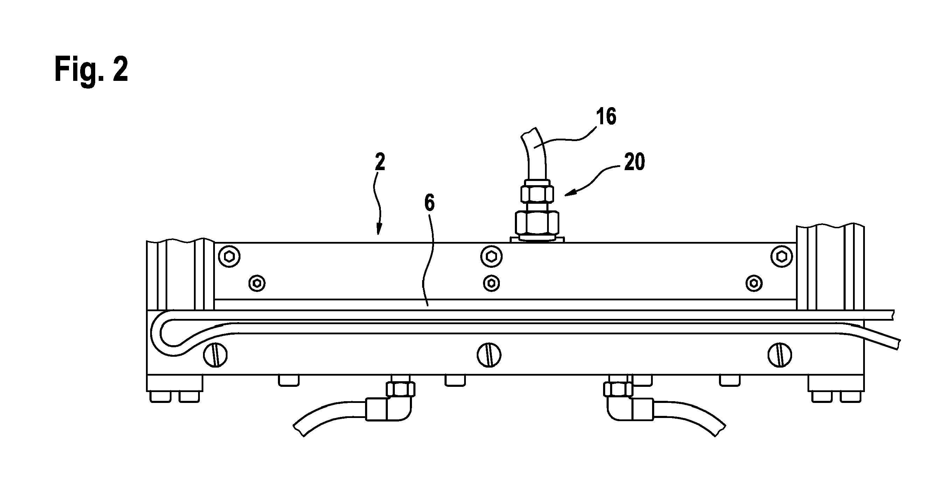

Fig. 2 zeigt die Elektronenquelle 2 in einer vergrößerten Darstellung und - teilweise - ein Koppelstück 20 für die Einkopplung von Hoch-Gleichspannung. Im Gegensatz zur Darstellung der Fig. 1 ist hier die Hochspannung über das Kabel 16 in die Mitte der Elektronenquelle 2 eingeführt.

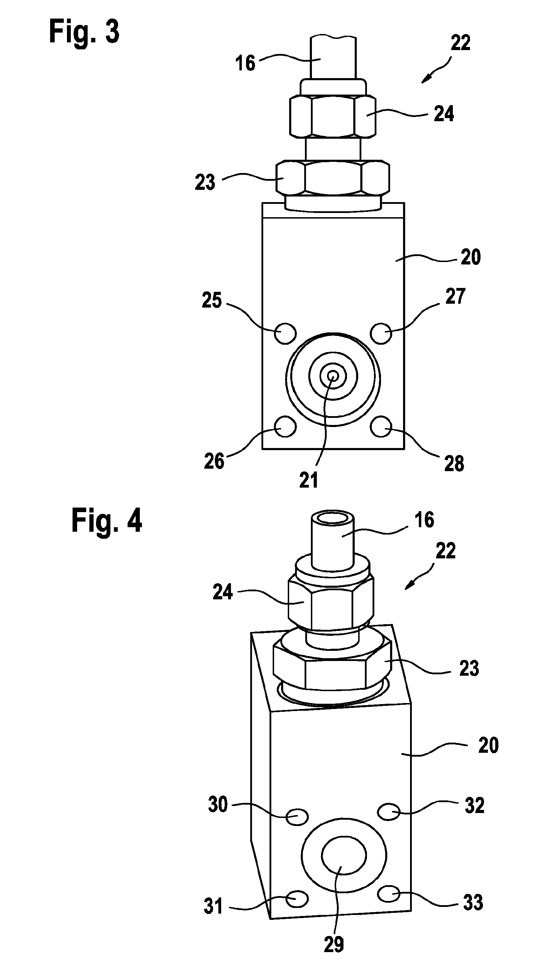

Das Koppelstück 20 ist in der Fig. 3 noch einmal in einer vergrößerten Darstellung gezeigt, und zwar von der Elektronenquelle 2 aus gesehen. Man erkennt hierbei eine runde Öffnung 21 zum Anschluss eines Steckkontakts an eine Hochspannungselektrode in der Elektronenquelle. Mit 22 ist eine so genannte Swagelok-Verschraubung bezeichnet, die zwei übereinander angeordnete Muttern 23, 24 aufweist. Um die Öffnung 21 herum sind vier Bohrungen 25 bis 28 vorgesehen. Die Bohrungen 25 ... 28 und 30 ... 33 sind die gleichen Durchgangsbohrungen, nur von verschiedenen Seiten aus gesehen. Dabei entspricht die Bohrung 25 der Bohrung 32, die Bohrung 27 der Bohrung 30, die Bohrung 28 der Bohrung 31 und die Bohrung 26 der Bohrung 33.

Die Fig. 4 stellt das Koppelstück 20 gegenüber Fig. 3 um 180 Grad um die Längsachse gedreht dar. Eine Öffnung 29 dient zum Anlöten eines Steckkontakts der Elektronenquelle 2 an die Seele des Hochspannungskabels. Um die Öffnung 29 herum sind vier Bohrungen 30 bis 33 angeordnet. Die Öffnung 29 dient dazu, ein Lötgerät zum Anlöten des Steckkontakts einführen zu können.

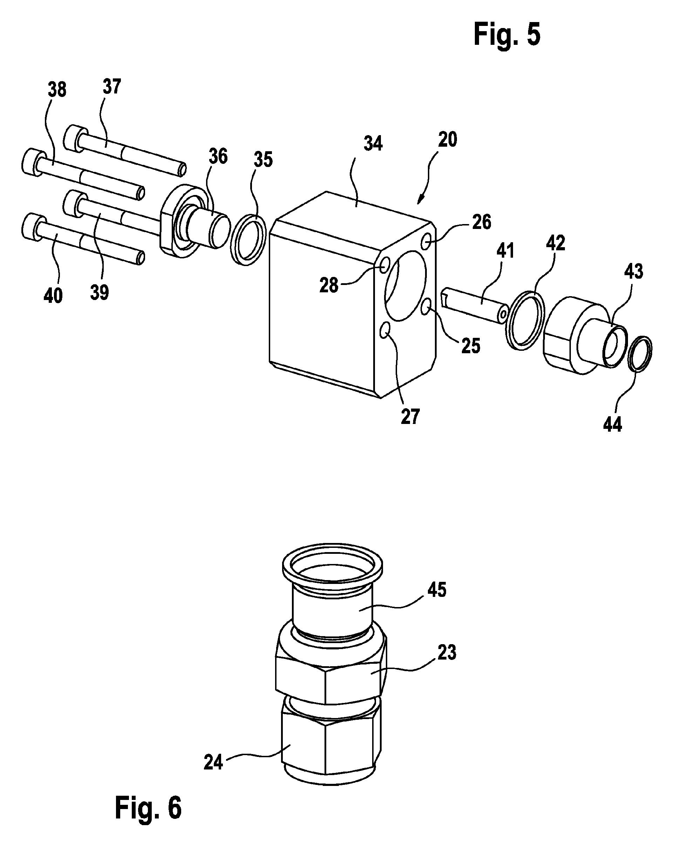

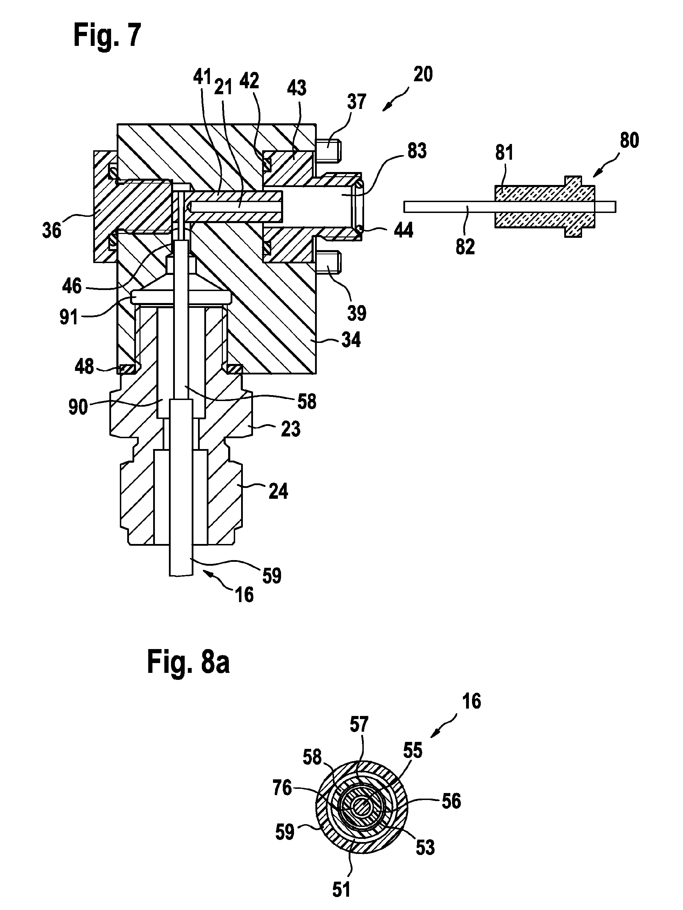

In der Fig. 5 ist eine Explosionsdarstellung des Koppelstücks 20 gezeigt, das an die Elektronenquelle 2 angeschraubt werden kann. Man erkennt hierbei einen Isolierkörper 34, einen Dichtring 35, ein Verschlussstück 36, vier Befestigungsschrauben 37 bis 40, einen Steckkontakt 41, einen Dichtring 42, ein durchbohrtes, schraubenförmiges Isolierteil 43 und einen weiteren Dichtring 44. Das Isolierteil 43 wird in die Elektronenquelle eingeschraubt. Das Schraubgewinde ist in Fig. 7 dargestellt. Die Bauteile 43, 44 bezeichnen dasjenige Ende des Koppelstücks 20, das zur Elektronenquelle 2 führt und in diese eingeschraubt wird. Die Swagelok-Verschraubung 22 mit den beiden Muttern 23, 24 ist in Fig. 5 nicht dargestellt. Die Öffnung 29 (Fig. 4) wird nach dem Anlöten des Steckkontakts mit dem Verschlussstück 36 (Fig. 5) verschlossen.

Eine perspektivische Darstellung dieser Swagelok-Verschraubung zeigt die Fig. 6. Man erkennt hierbei ein Ansatzstück 45, das aus der Mutter 23 herausragt. Bei dem oberen Teil des Ansatzstücks 45 handelt es sich um einen Dichtring.

Fig. 7 zeigt einen Schnitt durch das Koppelstück 20, das gegenüber der Darstellung in Fig. 3 um 180° um seine Querachse gedreht ist, d. h. diejenigen Elemente, die in Fig. 4 oben dargestellt sind, sind jetzt unten dargestellt. Außerdem ist es um 90° um seine Längsachse gedreht. Man erkennt hierbei die Muttern 23, 24, den Isolierkörper 34, die Steckbuchse 41, den Dichtring 42, das durchbohrte, schraubenförmige Isolierteil 43 sowie den Dichtring 44. Die Mutter 23 ist mit einem inneren Gewinde versehen. Außerdem erkennt man die Enden der Befestigungsschrauben 37, 39. Zwischen der Mutter 23 und dem Steckkontakt 41 ist eine Drahtführung 46 für einen Hochspannung führenden Draht 55 vorgesehen. Dieser Draht 55 ist die Seele des Hochspannungskabels 16; er wird mit der Steckbuchse 41 verlötet. Die Steckbuchse 41 wird dann auf einen Stift 82 gesteckt. Ein Isolator 80 umgibt diesen Stift 82. Im montierten Zustand befindet sich der Teil 81 des Isolators 80 in einer Aussparung 83 des Isolierteils 43. Der Isolator 80 mit dem Stift 82 ist Bestandteil der Elektronenquelle 2. Es wird also beim Anschluss des Hochspannungskabels 16 an die Elektronenquelle 2 das Koppelstück 20 auf den Isolator 80 aufgesteckt. Atmosphärendruck befindet sich in dem Kanal 51, und in den Ausnehmungen 90, 91, 83. Diese Bereiche bilden die eigentliche Isolierstrecke. Nach der Montage endet der Atmosphärendruck am Teil 81 des Isolators. Damit wird der Atmosphärendruck bis unmittelbar vor die Elektronenquelle 2 geführt, wodurch die Isolierstrecken gegen Überschläge geschützt sind.

Das Isolierteil 43 wird durch das Koppelstück nur geführt; es ist nicht in diesem befestigt. Das Koppelstück wird über das Isolierteil 43, das den Dichtring 42 trägt, gestülpt und an der Elektronenquelle mit den Schrauben 37 bis 40 festgezogen.

Das Isolierteil 43 ist in Fig. 3 nicht dargestellt. Dort ist nur die Ausnehmung rund um die Öffnung 21 zu sehen, in die das Isolierteil 43 eingepasst wird.

Ein Dichtring 48 ist zwischen dem Isolierkörper 34 und der Mutter 23 vorgesehen. Das bereits in Fig. 5 dargestellte Verschlussstück 36 wird nach der Herstellung der Verbindung zwischen der Seele 55 des Hochspannungskabels und der Steckbuchse 41 durch Verlöten in die Öffnung 29 eingeschraubt, die in Fig. 4 zu sehen ist.

In der Fig. 8a ist ein Querschnitt durch das in Vakuum verlaufende Hochspannungskabel 16 gezeigt. Die einzelnen Schichten des Hochspannungskabels 16 sind dabei nicht maßstäblich, sondern nur schematisch dargestellt. Dieses Hochspannungskabel 16 weist den Hochspannungsdraht 55 - die Seele des Kabels 16 - auf, der von einem Hochspannungsisolator 56 umgeben ist. Dieser Hochspannungsisolator 56 ist seinerseits von einer KupferAbschirmung 57 umgeben, um die eine Kunststoffisolierschicht 58 gelegt ist. Hierauf folgt ein Luftspalt 51, der einen Kontakt des Koppelstücks 20 mit der Umgebungsluft herstellt. Die äußere Hülle bildet ein vakuumdichter Isolierschlauch 59. Dieser Schlauch wird an der Durchführung 14 durch eine Quetschverbindung (z. B. Swagelok) vakuumdicht verschlossen. Die Kupferabschirmung 57 ist an Erdpotential gelegt. Zwischen dem Hochspannungsdraht 55 und dem Hochspannungsisolator 56 befindet sich ein Raum 76, der unter Atmosphärendruck steht. Entsprechend kann auch zwischen den anderen Schichten des Kabels 16 Luft durchtreten, sodass der Hochspannungsdraht 55 innerhalb der Vakuumkammer 1 von Atmosphärendruck umgeben ist. Die Teile 55 bis 58 sind Bestandteil eines handelsüblichen Hochspannungskabels. Der zusätzliche Isolierschlauch 59, der auch ein Isolierrohr sein kann, bildet mit dem Kunststoffisolierschlauch 58 einen Luftkanal 51. Auch dieser Luftkanal 51 gewährleistet die Zuführung von Atmosphärendruck.

Gemäß Fig. 8a scheint der Luftspalt 51, in dem sich Atmosphäre befindet, keinen Zugriff auf die Isolierschraube zwischen dem Kern 55 und der Abschirmung 57 zu haben. Dieser Zugriff wird jedoch dadurch realisiert, das die Luft zuerst bis zum Koppelstück 20 läuft und dann zurück in den Zwischenraum zwischen Abschirmung 57 und Kern 55. Ein anderer Weg für den Atmosphärendruck ergibt sich am Kabelanschluss außerhalb des Vakuumbehälters, der ja nicht vakuumdicht ausgeführt ist.

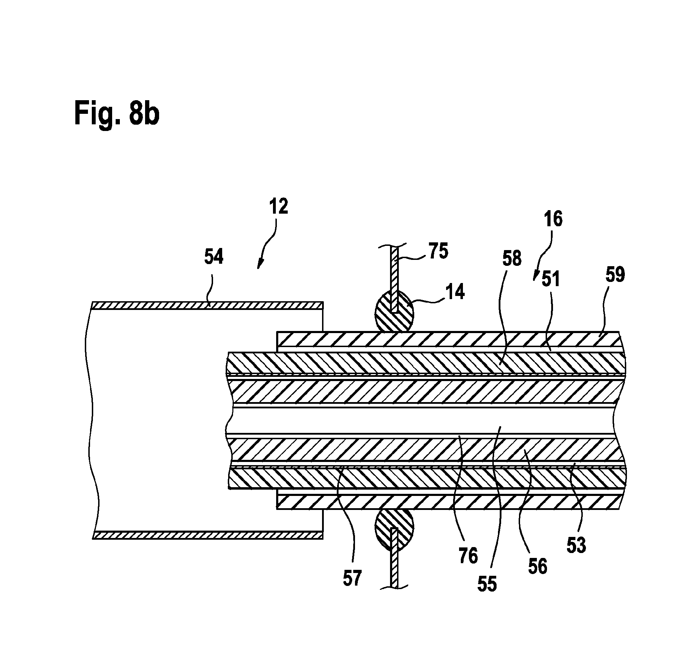

In der Fig. 8b ist ein Längsschnitt durch die Kabel 12 und 16 im Übergangsbereich zwischen Atmosphäre und Vakuum dargestellt. Mit 75 ist eine Wand der Vakuumkammer 1 angedeutet. Man erkennt hierbei, dass das Hochspannungskabel 12 im Außenbereich anders aufgebaut ist als das weiterführende Hochspannungskabel 16 im Vakuumbereich. Der Aufbau des Hochspannungskabels 16 im Vakuum ist bereits in Fig. 8a im Querschnitt gezeigt. Wie man aus Fig. 8b erkennt, reicht der vakuumdichte Schlauch 59 über die Durchführung 14 hinaus in Atmosphäre, aber nur ein kleines Stück. Dann wird dieser Schlauch 59 gewissermaßen abgelöst von einem Metallschlauch oder -rohr 54, der das Ende dieses Schlauchs 59 umgibt. Die Bezugszahlen 76, 53 bezeichnen Stellen, in denen Atmosphäre eintreten kann. Die Atmosphärenluft wird jedoch überwiegend von dem Kanal 51 zwischen die Schichten 58 und 59 geführt. Es wird nur außen am Schlauch 59 vakuumdicht verbunden, nicht innen zwischen der Schicht 58 und dem Schlauch 59 oder zwischen der Schicht 58 und dem Hochspannungsisolator 56.

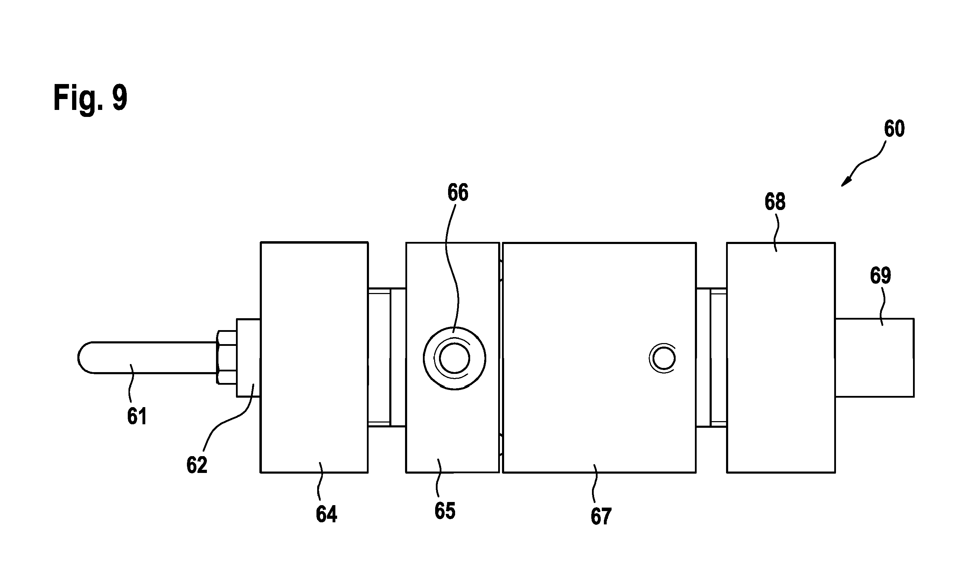

Die Fig. 9 zeigt eine Kabelkupplung 60 für das Kabel 17, das zur Ionenquelle 3 führt. Mit dieser Kabelkupplung wird die Hochfrequenzspannung an die Ionenquelle 3 angekoppelt. Ein Steckkontakt 61 wird in die Elektrode der Ionenquelle 3 eingeführt. Er ist von einer Metallbuchse 62 umgeben, an die eine in Fig. 9 nicht dargestellte Hochfrequenzleitung stößt. Diese Metallbuchse 62 ist von einer Kunststoff-Muffe 64 umgeben. In diese Kunststoff-Muffe 64 ist ein Isolierteil 65 eingeführt, das mit einer Öffnung 66 versehen ist. Durch diese Öffnung wird Atmosphärendruck oder noch größerer Druck zugeführt, wenn die Zufuhr von Atmosphärendruck durch die Luftspalte zwischen den einzelnen Schichten 63, 74, 69 des Kabels 17 nicht ausreichen sollte. Die durch die Öffnung 66 geführte Atmosphärenluft wird beispielsweise mittels eines vakuumfesten Schlauchs herangeführt, der durch die Vakuumkammer verläuft und nach draußen führt. An das Isolierteil 65 schließt ein Metall-Schirmanschluss 67 für die Ionenquelle 3 an. Den Abschluss bilden eine Kunststoff-Muffe 68 und ein Kabelmantel 69 aus z. B. Polyethylen. Der Metall-Schirmanschluss 67 ist an Masse gelegt, um die Rückleitung des Stroms zu gewährleisten. Im Schirmanschluss 67 oder im Isolierteil 65 können Gewindebohrungen vorgesehen sein, die als Zugentlastung oder für die Befestigung des Kabels dienen. Die Zugentlastung für den gesamten Stecker mit HF-Kabel wird dabei durch Anschrauben des Isolierteils 65 an einem Haltewinkel bewirkt. Dafür werden die Gewindebohrungen benutzt.

Eine der Öffnung 66 entsprechende Öffnung kann auch in der Kupplung für die Elektronenquelle 2 gemäß den Fig. 3 bis 7 vorgesehen sein.

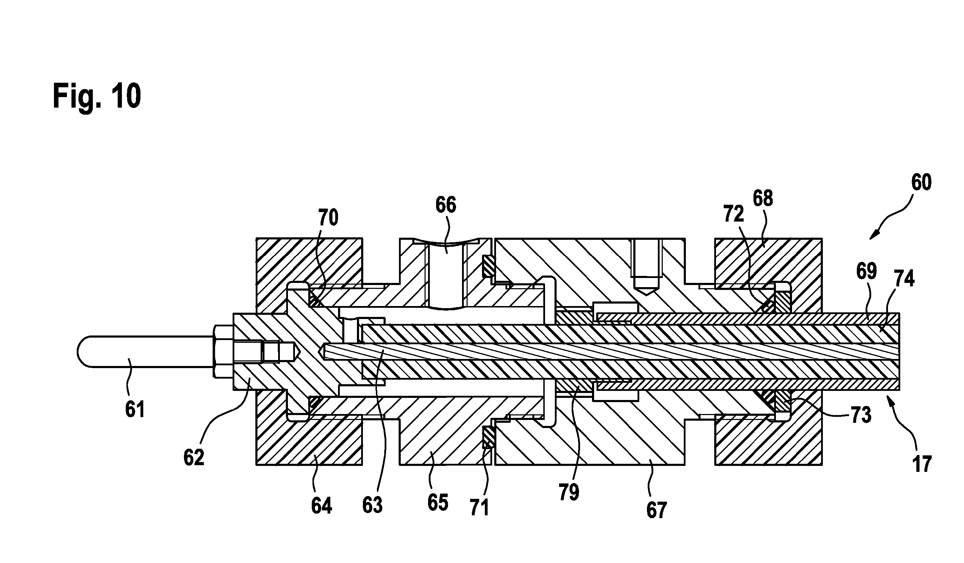

In der Fig. 10 ist die Kabelkupplung 60 der Fig. 9 in einem Längsschnitt dargestellt. Man erkennt hierbei wieder den Steckkontakt 61, der in eine Metallbuchse 62 eingeschraubt ist. Eine Hochfrequenzleitung 63 ist in die Metallbuchse 62 eingelötet. Das Isolierteil mit der Öffnung 66 stößt über einen Dichtring 70 an die Metallbuchse 62. Die elektrische Verbindung zwischen dem Steckkontakt 61 und der Hochfrequenzleitung 63 erfolgt über die Metallbuchse 62.

Der Schirmanschluss 67 stößt über einen Dichtring 71 auf der linken Seite an das Isolierteil 65 und an der rechten Seite über einen Dichtring 72 an eine Isolierscheibe 73, die von der Kunststoff-Muffe 68 umgeben ist. Diese Kunststoff-Muffe 68 umschließt auch Teile des Schirmanschlusses 67.

Die Hochfrequenzleitung 63 ist von einer Isolierung 74 umgeben, die ihrerseits von dem Kabelmantel 69 umgeben ist. Außerhalb der Kabelkupplung 60 ist der Kabelmantel 69 von einem nicht dargestellten Kunststoffmantel umhüllt. Wie man aus der Fig. 10 erkennt, gelangt die Atmosphäre bzw. ein höherer Druck durch die Öffnung 66 in die eigentliche Isolierstrecke, die hier durch den Hohlraum um die Isolierung 74 herum gebildet wird.

Die Hochspannungen, die zu der Elektronenquelle 2 geführt werden, liegen in der Praxis zwischen 5 und 10 kV. Dagegen beträgt die Spannung der Hochfrequenzspannung etwa 1 kV. Die Gefahr von Glimm- oder Plasmaentladungen ist bei dem Hochfrequenzkabel 17 somit geringer als beim Hochspannungskabel 16. Es fließen jedoch durch das Hochfrequenzkabel 17 relativ hohe Ströme in der Größenordnung von 10 bis 20 Ampere, was zu einer Plasmabildung in der Isolierstrecke und Vakuumkammer 1 führen kann. Dieses Plasma kann den äußeren Mantel des Hochfrequenzkabels 17 aufschmelzen.

Es scheint zwar, als ob kein Vakuum in die Isolierstrecke gelangen kann, wenn die Verbindung zwischen Kabel 17 und Ionenquelle dann hergestellt wird, wenn die Vakuumkammer 1 noch nicht evakuiert ist. Wird die Vakuumkammer 1 anschließend evakuiert, scheint kein Vakuum in das Kabel mehr eindringen zu können. Man kann jedoch nicht davon ausgehen, dass alle Verbindungen absolut dicht bleiben. Bei einem geringsten Leck würde der Innendruck des Steckers absinken und Entladungen zur Folge haben. Um den Atmosphärendruck im Innern zu sichern, ist deshalb der Steckkontakt 61 angebracht. Das HF-Kabel 17 weist eine Abschirmung auf, und zwar zwischen dem Kabelmantel 69 und der Isolierung 74. Diese Abschirmung weist über den dünneren Teil der Buchse 79 hinaus und kontaktiert dort durch Einschrauben der Buchse 79 mit dieser. Die Abschirmung ist in Fig. 10 nicht dargestellt.

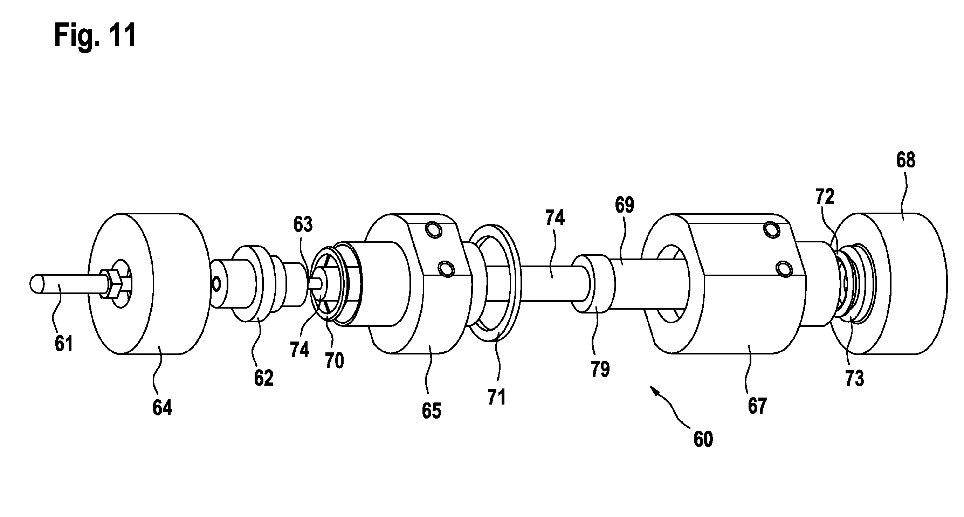

Wird bei der Zuführung der Hochfrequenzspannung an die Ionenquelle 3 nicht die in den Fig. 10 und 11 gezeigte Kupplung 60, sondern ein Hohlleiter verwendet, so ist dieser Hohlleiter vorzugsweise ein Koaxialhohlleiter mit einem runden Innenleiter und einem diesen umgebenden Außenleiter. Zwischen Innenleiter und Außenleiter kann dann Atmosphärendruck herrschen.

In der Fig. 11 ist die Kabelkupplung 60 noch einmal in einer Explosionsdarstellung gezeigt, wobei diejenige Seite oben liegt, die in Fig. 9 unten liegt. Man erkennt hierbei wieder den Steckkontakt 61, die Kunststoff-Muffe 64, die Metallbuchse 62, die HF-Leitung 63, die Isolation 74, das Isolierteil 65, den Dichtring 70, den Dichtring 71, die Buchse 79, den Kabelmantel 69, den Schirmanschluss 67, den Dichtring 72, das Teil 73 und die Kunststoff-Muffe 68. Der Anschluss der Ionenquelle 3 an die HF-Spannung geschieht durch Einstecken des Steckkontakts 61 direkt in eine nicht dargestellte Elektrode der Ionenquelle 3.

## Patentansprüche

1. Spannungszuführung zu wenigstens einem elektrischen Verbraucher (2, 3), der sich in einer Vakuumkammer (1) befindet, mit einem Kabel (12, 16; 13, 17), das einen spannungsführenden Kern (55) und wenigstens einen diesen Kern (55) umgebenden Isolierkörper (59) aufweist, **dadurch gekennzeichnet, dass** zwischen dem Kern (55) und dem Isolierkörper (59) bis unmittelbar vor der Verbindung des Endes des Kerns (55) mit einem elektrischen Anschluss (80 - 82) des Verbrauchers (2, 3) Atmosphärendruck oder ein darüber liegender Druck herrscht.

2. Spannungszuführung nach Anspruch 1, **dadurch gekennzeichnet, dass** der Isolierkörper (59) ein vakuumdichter Schlauch ist.

3. Spannungszuführung nach Anspruch 1, **dadurch gekennzeichnet, dass** der Isolierkörper ein vakuumdichtes Rohr ist.

4. Spannungszuführung nach Anspruch 1, **dadurch gekennzeichnet, dass** das Kabel (12, 16) ein Gleichstrom-Hochspannungskabel ist.

5. Spannungszuführung nach Anspruch 1, **dadurch gekennzeichnet, dass** das Kabel (13, 17) ein Hochfrequenzkabel ist.

6. Spannungszuführung nach Anspruch 5, **dadurch gekennzeichnet, dass** das Kabel ein Hohlleiter ist.

7. Spannungszuführung nach Anspruch 1 und Anspruch 4, **dadurch gekennzeichnet, dass** der elektrische Verbraucher eine Elektronenquelle (2) ist.

8. Spannungszuführung nach Anspruch 1, Anspruch 5 oder Anspruch 6, **dadurch gekennzeichnet, dass** der elektrische Verbraucher eine Ionenquelle (3) ist.

9. Spannungszuführung nach Anspruch 1, **dadurch gekennzeichnet, dass** es über Vakuumdurchführungen (14, 15) in die Vakuumkammer (1) eingeführt ist.

10. Spannungszuführung nach Anspruch 4, **dadurch gekennzeichnet, dass** das eine Ende des Gleichstrom-Hochspannungskabels (16) mit einem Koppelstück (20) verbunden ist, wobei das Koppelstück (20) eine Öffnung (21) für die Durchführung eines Hochspannungssteckers (82) aufweist.

11. Spannungszuführung nach Anspruch 10, **dadurch gekennzeichnet, dass** das Koppelstück (20) eine Öffnung (29) aufweist, durch welche mit Hilfe eines Lötwerkzeugs der Hochspannungsstecker (82) mit dem Kern (55) des Hochspannungskabels (16) verlötbar ist.

12. Spannungszuführung nach Anspruch 1, **dadurch gekennzeichnet, dass** zwischen dem Kern (55) und dem Isolierkörper (59) ein Hochspannungsisolator (56) vorgesehen ist.

13. Spannungszuführung nach Anspruch 12, **dadurch gekennzeichnet, dass** zwischen dem Hochspannungsisolator (56) und dem Isolierkörper (59) eine metallische Abschirmung (57) vorgesehen ist.

14. Spannungszuführung nach Anspruch 13, **dadurch gekennzeichnet, dass** zwischen der metallischen Abschirmung (57) und dem Isolierkörper (59) eine Kunststoffschicht (58) vorgesehen ist.

15. Spannungszuführung nach Anspruch 5, **dadurch gekennzeichnet, dass** das Hochfrequenzkabel eine Hochfrequenzleitung (63) aufweist, die von einer Isolierung (74) umgeben ist.

16. Spannungszuführung nach Anspruch 15, **dadurch gekennzeichnet, dass** die Isolierung (74) von einem Kabelmantel (69) umgeben ist.

17. Spannungszuführung nach Anspruch 5, **dadurch gekennzeichnet, dass** das Hochfrequenzkabel mit einer Kabelkupplung (60) verbunden ist, das einen Steckkontakt (61) für den Anschluss an einen Hochfrequenzverbraucher aufweist.

18. Spannungszuführung nach Anspruch 1, **dadurch gekennzeichnet, dass** die Kabelkupplungen (20, 60) wenigstens eine Öffnung (66) für die Zuführung von Atmosphärendruck oder einem darüber liegenden Druck aufweisen.

19. Spannungszuführung nach einem oder mehreren der vorhergehenden Ansprüche, **dadurch gekennzeichnet, dass** der Steckkontakt (61) über eine Metallbuchse (62) mit der Hochfrequenzleitung in Verbindung steht.
